# EUROPEAN PATENT APPLICATION

(11) **EP 4 203 274 A1**
(43) Date of publication of application: **28.06.2023**
(21) Application number: 21217596.2
(22) Date of filing: 23.12.2021
(51) Int. Cl.: H02K 11/33

(54) **ELECTRICAL GENERATOR SYSTEM**

(71) Applicant: Rolls-Royce Deutschland Ltd & Co KG, 15827 Blankenfelde-Mahlow (DE)
(72) Inventor: ANTAL, Ferenc, 2146 Mogyoród (HU); FODOR, Tamás Attila, 3950 Sárospatak (HU); LÉGÁR, András Zsigmond, 1161 Budapest (HU); SÜLE, Tibor, 8600 Siófok (HU)
(74) Representative: Maikowski & Ninnemann Patentanwälte Partnerschaft mbB

(57) **Abstract**

The invention relates to an electrical generator system (100) comprising a generator unit (10) and an inverter unit (20), the generator unit (10) coupled to the inverter unit (20) through a coupling means (30), wherein the coupling means (30) comprises at least one busbar connection (41, 42).

## Description

The following relates to an electrical generator system with the features of claim 1.

Electrical generators are used in many applications, increasingly also in propulsion systems for aircrafts. AC generators used in this context can require a coupling with an inverter. An inverter is a device changing a DC current into an AC current required in this case by the generator.

For this purpose, it is e.g. known that generators and inverters as separate units are coupled by cables. As several cables are required for the electrical connection, the weight of the overall generator system is increased.

In particular in aircraft or aerospace applications, lightweight and compact solutions are required.

The system with the features of claim 1 addresses these issues.

The electrical generator system comprises a generator unit and an inverter unit, the generator unit coupled to the inverter unit through a coupling means, wherein the coupling means comprise at least one busbar connection. This provides a cable-free electrical connection between the generator unit and the inverter unit.

A busbar can e.g. be a metallic contact (plug, bar, strip etc,). The busbar is generally uninsulated and has sufficient mechanical stiffness, unlike a cable.

In one embodiment, the generator unit comprises at least one a male part of the busbar connection and the inverter unit comprises at least one female part of the busbar connection.

For sufficient mechanical stiffness the male part of the busbar connection can have a length to diameter ratio between 7:1 to 3:1.

In another embodiment, a busbar insulator element electrically insulates the busbar connection, in particular the female part of the busbar connection against other elements of the generator system. The busbar insulator element, in particular, can comprise a tubular section for an electrical insulation in radial direction and / or a disc-like element, in particular attached to the tubular section for an electrical insulation in axial direction. Such a design can e.g. achieve insulation effect in more than one direction. For an effective axial insulation the disc-like element of the busbar insulator element has an outer diameter being 1,2 to 2 times the inner diameter of the tubular section.

As the electrical generator system emits heat, the busbar connection, in particular the male part and / or the female part, can be thermally coupled to a cooling device, in particular a heat sink and / or an active cooling medium. The heat sink can be a passive cooling medium such as e.g. a inverter unit part with a suitably high heat capacity.

In another embodiment the female part of the busbar connection and / or the male part of the busbar connection are electrically coupled to a transducer for measuring the current and / or the voltage at the busbar connection. The current data can be used in the control of the generator system.

The busbar connection can comprise a receiving element with the female part of the busbar connection. In particular, the terminal electrical contacts of the receiving element can be offset from each other. This provides some design flexibility to have the electrical terminals at very different locations while still being connected through the busbar connection with the receiving element.

In a further embodiment, the female part of the busbar connection comprises a tubular part and at least one connection element for establishing an electric connection with the inverter unit and / or the generator unit. The receiving element allows for a geometric flexibility to geometrically decouple the tubular female part (and the matching plug shaped male part) and the connection to other parts in the generator unit and / or the inverter unit. For example, the at least one connection element is positioned above or below a plane of the axis of the tubular female part of the busbar connection. For good electrical conductivity the receiving element comprises copper or is made from copper. On the outside, the receiving element can comprise some insulation material, in particular a foil material.

In another embodiment, at least one part, in particular the heat sink and / or the busbar connection with the receiving element, is axially adjustable with an adjustment means relative to a fixed part in the generator unit and / or inverter unit, in particular the generator unit housing and / or the inverter unit housing. This axial adjustability can prevent an overconstraining of the assembly.

Embodiments of the invention are shown in the figures, where
Fig. 1 shows a perspective view of an embodiment of an electrical generator system with a generator and an inverter as separate units;
Fig. 2 shows a sectional view of a detail of the generator unit and the inverter unit of Fig. 1 connected by a busbar connection;
Fig. 3A shows a perspective rear view of a busbar insulator element;
Fig. 3B shows a perspective frontal view of the busbar insulator element of Fig. 3A;
Fig. 4 shows a perspective view of the busbar connection in the inverter unit;
Fig. 5 shows a perspective view of the busbar connection of Fig. 4 with a clamping element removed;
Fig. 6 shows a perspective view of the busbar connection of Fig. 5 with a busbar insulator element removed;
Fig. 7 shows a perspective view of the busbar connection of Fig. 6 with a current transducer removed, showing a receiving element of the busbar connection;
Fig. 8 shows a perspective view of an embodiment of a clamping element;
Fig. 9. Shows a perspective view of an embodiment of a fixing nut;
Fig. 10 shows a perspective view of the receiving element;
Fig. 11A shows a perspective sectional view of the transducer coupled to the busbar connection;
Fig. 11B shows a frontal view of the inverter unit with a plurality of transducers;
Fig. 12 a shows perspective overview of the inverter unit;
Fig. 13 shows a sectional view through a detail of the inverter unit showing an axial adjustment means.

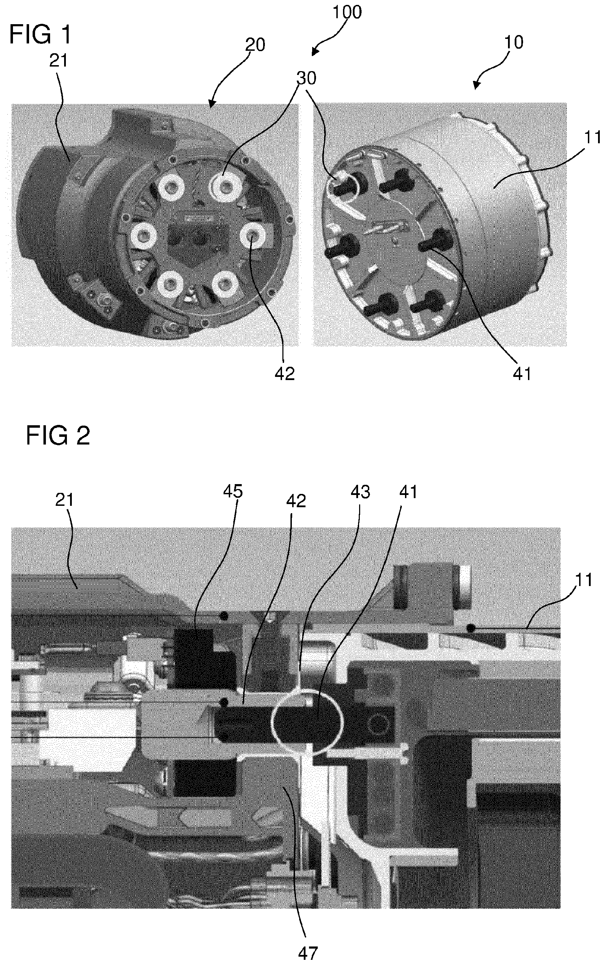

In the following Fig. 1 to 13, details of an exemplary embodiment of an AC generator system 100 comprising a generator unit 10 and an inverter unit 20 are described. The relevant elements visible in the figures are described in their technical context, not every figure.

Fig. 1 shows an electrical generator unit 10 on the right and an inverter unit 20 on the left in a non-connected situation. The generator unit 10 and the inverter unit 20 comprise respective housings 11, 21.

In an assembled, electrically connected situation (in part e.g. shown in Fig. 2) it is the aim to provide the electrical generator system 100 which is lightweight and compactly connected so that it can in particular be used in an aerospace or aircraft context.

The generator unit 10 is coupled to the inverter unit 20 through a coupling means 30, wherein the coupling means 30 comprises at least one busbar connection 41, 42.

As can be seen in Fig. 1 and in more detail in the following figures, the generator unit 10 comprises a plurality (here six) of male parts 41 of the busbar connection. The inverter unit 20 comprises the matching plurality of female parts 42 of the busbar connection.

In other embodiments, the generator unit 10 comprises the female parts and the inverter unit 20 the male parts. Also mixed arrangement of male parts 41 and female parts 42 are possible.

The busbar connection with the male and female parts 41, 42 enables a direct, non-cable connection between the generator unit 10 and the inverter unit 20, saving volume and weight.

The male part 41 is dimensioned as a cylindrical plug with a circular cross-section. The ratio of the length to diameter is about 5:1. The plug-shaped male part 41 of the busbar connection (and the corresponding female part 42) defines an axial direction A, which is referred to in the following description.

In other embodiments, the length-diameter ratio of the male part 41 can be between 7:1 and 3:1, ensuring a stable, robust electrical connection. In further embodiments, the male part 41 can have a different shape, e.g. a rectangular, plate-like shape or a tubular shape. The cross-section can also be non-circular e.g. polygonal or elliptic. The female part 42 of the busbar connection is complementary shaped to the male part 41.

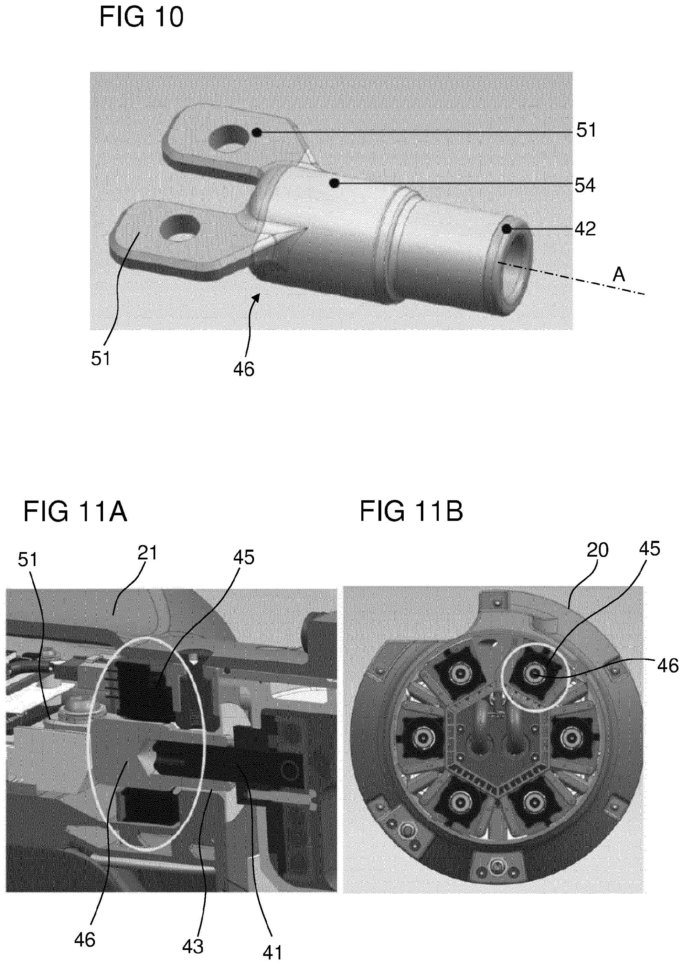

The female part 42 of the busbar connection is shown in more detail in Fig. 10.

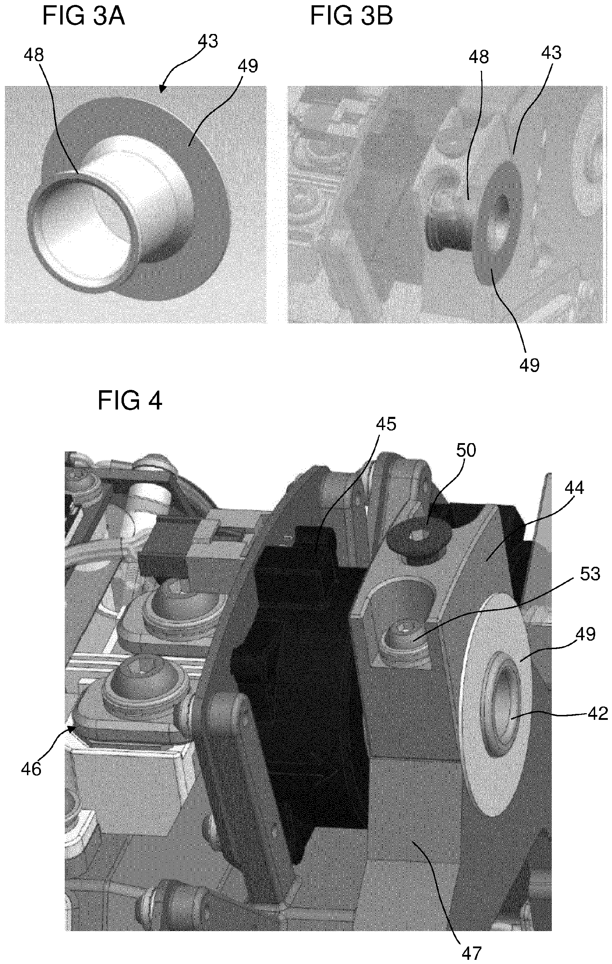

As the electrical current flows through the male and female parts 41, 42, some electrical insulation against other parts is introduced circumferentially on the outside of the female part 42 in the form of a busbar insulator element 43, shown in more detail in Fig. 3A and 3B.

The busbar insulator element 43 essentially comprises a tubular section 48 (seen in the front of Fig. 3A) which on one end comprises a disc-like element 49. The tubular section 48 electrically insulates the female part 42 radially, the disc-like element 49 axially against other parts of the inverter unit, as can be seen in Fig. 2. The outer diameter of the disc-like element 49 can be between 1,2 to 2 times the inner diameter of the tubular section 48. The busbar insulator element 43 can be e.g. made from resin and can be produced through a 3D printing process.

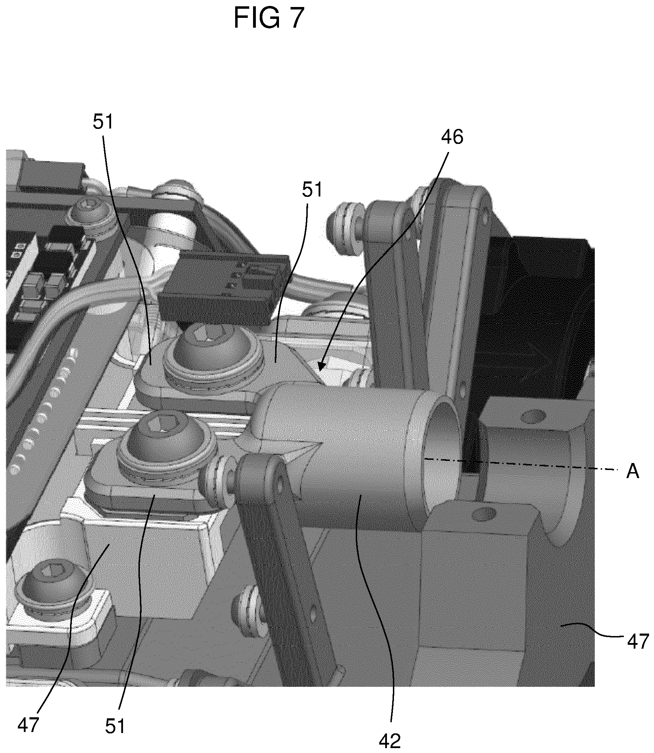

As indicated above, the axial direction A defines the axis along the male part 4 of the busbar connection is inserted into the female part 42. The axis A extends along a tubular part of the female part 42 of the busbar connection (see e.g. Fig. 7).

In the assembly shown in Fig. 2, the busbar insulator element 43 prevents current from leaking e.g. into a heat sink 47 and into a clamping element 44 (shown in detail e.g. in Fig. 4). The heat sink 47 provides some cooling capability to the busbar connection. The heat sink 47 can e.g. be part of the inverter unit 20 and can be manufactured e.g. by a 3D printing process.

The heat sink 47 - as a passive device - is just one of the possible cooling devices to cool the busbar connection. In other embodiments, an active cooling, e.g. using a cooling fluid thermally coupled to the busbar connection, can be used.

The busbar connection with the male part 41 and the female part 42 should remain in place relative to other parts of the inverter unit 20 for ensuring a safe electrical connection between the generator unit 10 and the inverter unit 20. But it is also an issue to keep the busbar connection free - as far as technically possible - from dynamic stresses, e.g. mechanical stresses. Furthermore, the busbar connection should have a good heat exchange with the cooling device, here the heat sink 47. Therefore, a tight screw connection with fastening screes 53 (see e.g. in Fig. 4) in the embodiment shown presses the heat sink 47 against the busbar connection ensuring low thermal resistance.

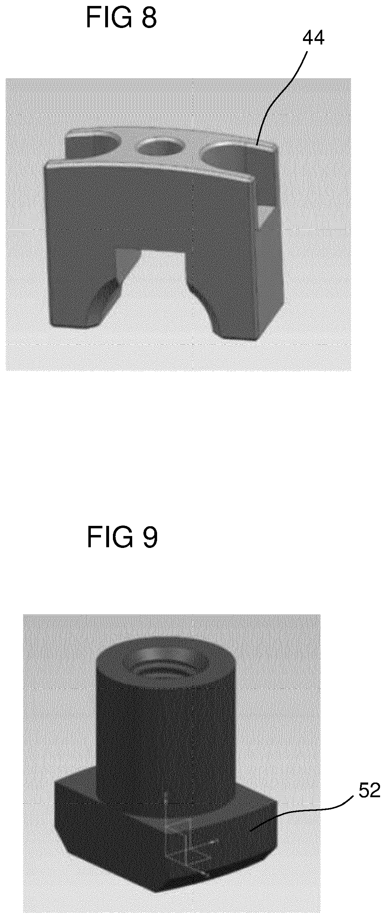

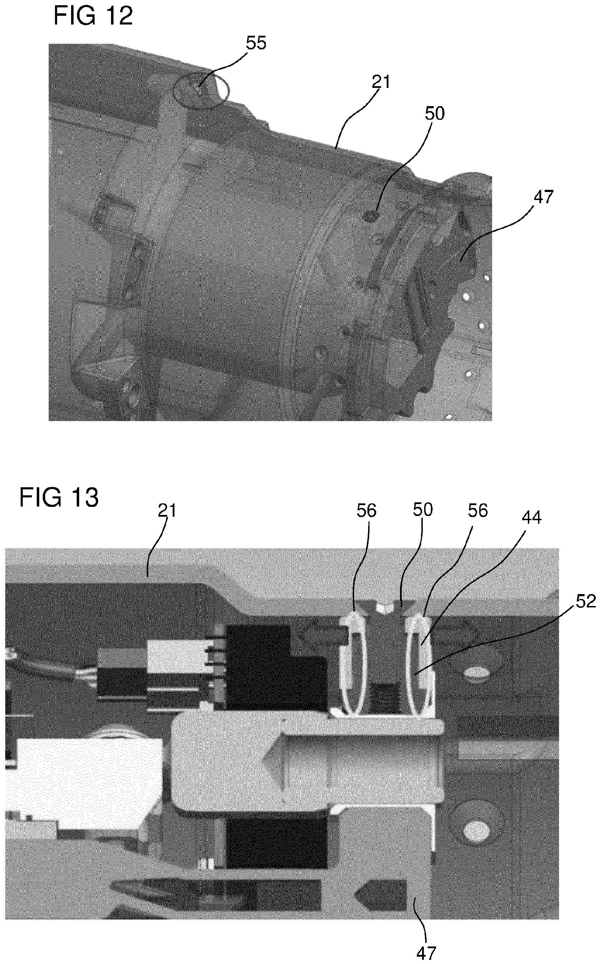

In Fig. 4, a fastener 50 (here a screw) for adjusting the axial position within the clamping element 44 is shown in a partly unscrewed position. Details of the axial adjusting are described in connection with Fig. 12 and 13. The clamping element 44 itself is shown in more detail in Fig. 8.

The clamping element 44 fixesthe busbar insulator element 43 against a rigid part of the inverter unit 10 by using the fastening screws 53. Thereby, it suppresses vibrations in the busbar connection. The clamping also improved the heat transfer from the busbar connection to the heat sink 47.

In Fig. 4 only the disc-like element 49 of the bus bar insulator element 43 is depicted. The busbar insulator element 43 surrounds the female part 42 of the busbar connection. An electrical transducer 45 is positioned axially behind the clamping element 44 for measuring the current flowing through the busbar connection. The term "behind" in this context is defined relative to the opening of the female part 42 of the busbar connection which is defined as the "front."

The electrical transducer 45 is connected through a board with the body of the inverter unit 20. Further details are shown in Fig. 11A and 11B.

A cross-section of the electrical transducer 45 is shown in Fig. 2, showing the electrical connection with the axial rear part of the female part 42 of the busbar connection.

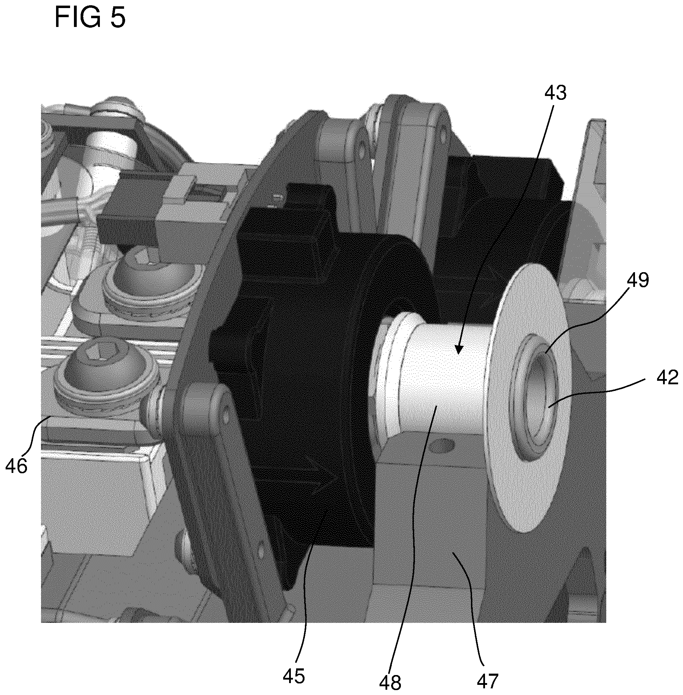

In Fig. 5 to 7 the busbar connection of the embodiment discussed herein is shown in different views. Generally some parts are removed to show part hidden from view in other figures.

Fig. 5 generally shows the same view as in Fig. 4, but with the clamping element 44 removed. This allows a more complete view of the busbar insulator element 43.

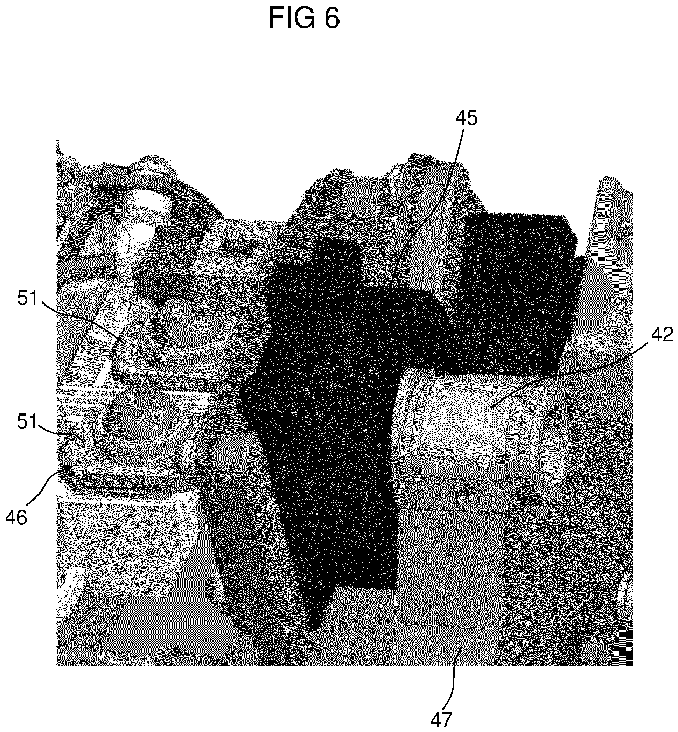

Fig. 6 generally shows the same view as in Fig. 5, but with the busbar insulator element 43 removed. This shows the tubular part of the female part 42 of the busbar connection.

Fig. 7 generally shows the same view as in Fig. 6 but with the transducer 45 and its board removed.

The female part 42 of the busbar connection is part of a receiving element 46 which comprises two connection elements 51. As can be seen in more detail in Fig. 10, the two connection elements 51 are positioned laterally at the opposite end to the opening of the female part 42. Furthermore, the connection elements 51 are positioned above the axis A. The connection elements 51 in the embodiment shown are two plates which are mounted above the plane with the axis A. This allows that the receiving element 46 can be fastened to the inverter unit 20 in a volume-economic way. Both plates of the connection elements 51 comprise holes for the screw connection shown e.g. in Fig. 7. The current flowing through the busbar connection flows through the tubular female part 42 and through the plates 51. The material underneath of the connection element 51 can also be designed to be a heat sink 47 to keep this part of the busbar connection cool.

In other embodiments only one connection element 51 or more than two connection elements 51 - not necessarily shaped as a plate - can be used to establish the electrical connection through the busbar connection.

In Fig. 8, the clamping element 44 is shown without the inverter unit 20 and other parts. The clamping element is essentially shaped as an arch. On the top side two fastening screws 53 can be inserted on the right and left hand side (see e.g. Fig. 4). In the middle between those fastening screws 53 the radial fastener 50 (see e.g. Fig. 4) can be used to axially adjust the assembly as will be described below in connection with Fig. 12 and 13.

Fig. 9 shows a fixing nut 52 as the counterpart of the radial fastener 50 (also seen e.g. in Fig. 4) which is used for the adjustment.

Fig. 10 shows the receiving element 46 with the essentially tubular female part 42 of the busbar connection on the right hand side, i.e. the frontal side. On the left hand side, i.e. the rear, the two connection elements 51, each with a bore for taking up screws of fastening the receiving element 46 to a part in the inverter unit 20. By attaching the connection elements 51 in a plane higher than the plane of the axis A, i.e. radially off center, the receiving element 46 can be fitted into the inverter unit 20 with a very small volume. There is a radial offset between the female part 46 as a first terminal electrical contact and the connection elements 51 as a second terminal electrical contact.

This shows that the receiving element 46 can have a more complex busbar form, to transport the current within the inverter unit 20. This means that the female part 42 of the busbar connection and the other parts of the inverter unit 20 can be designed independently from each other. The busbar connection with the receiving element 46 can bridge e.g. radial distances if that helps to keep the overall volume small.

The receiving element 46, or at least parts of it, are made from copper 1000 which can be produced by milling, but it could also be manufactured by a casting process. The surface of the receiving element 46 is at least partially coated with nickel. To electrically insulate the receiving element 46 against other parts of the inverter unit 20, it comprises insulation material 54, such as e.g. Kapton foil.

In Fig. 11A and 11B more details of the transducer 45 are shown. Axially behind the busbar insulator element 43, the current transducer 45 surrounds the receiving element 46 concentrically. Fig. 11B shows the inverter unit 20 in an axial view with six transducers 45 surrounding the six receiving elements 46.

In Fig. 12 and 13 some means for axially adjusting the busbar connection axially relative to other parts in the inverter unit 20 are described. This prevents overconstraining the structure.

In Fig. 12 the 3D printed heat sink 47 is shown to be fastened with screws 55 (only one shown) to the inverter housing 21, in several locations. All of these screws are in axial screw connections. As the clamping element 44 is fixed against the heat sink 47 as well (see Fig. 4), some axial flexibility is required to prevent an overconstraining.

To that effect within the clamping element 44 axial gaps 56 (encircled in Fig. 13) are provided. This allows an axial adjustment (see arrows in Fig. 13) of the inverter housing 21 relative to the heat sink 47 (and the receiving element 46). The radial screw 50 (see e.g. Fig. 2, 4 or 12) is threaded with the fixing nut 52 (see also e.g. Fig. 2). By tightening the radial fastener screw 50, the axial position can be fixed, i.e. this determines the relative axial position of the housing 21 to the heat sink 47.

The axial adjustment enables an easier assembly as tolerances can be overcome and it can help in adjusting for thermal expansions.

### List of reference numbers

- 10: generator unit
- 11: generator housing

- 20: inverter unit
- 21: inverter housing

- 30: coupling means

- 41: male part of busbar connection
- 42: female part of busbar connection
- 43: busbar insulator element
- 44: clamping element
- 45: current transducer
- 46: receiving element of busbar connection
- 47: heat sink
- 48: tubular section
- 49: disc-like element
- 50: radial fastener
- 51: connection element of receiving element
- 52: fixing nut for the fastener
- 53: fastening screws
- 54: insulation material of receiving element
- 55: screw connecting heat sink with inverter housing
- 56: axial gap in clamping element

- 100: generator system

- A: axis of male/female part of the busbar connection

## Claims

1. Electrical generator system (100) comprising a generator unit (10) and an inverter unit (20), the generator unit (10) coupled to the inverter unit (20) through a coupling means (30), wherein the coupling means (30) comprises at least one busbar connection (41, 42).

2. Electrical generator system according to claim 1, wherein the generator unit (10) comprises at least one a male part (41) of the busbar connection and the inverter unit (20) comprises at least one female part (42) of the busbar connection.

3. Electrical generator system according to claim 1 or 2, wherein the male part (41) of the busbar connection has a length to diameter ratio between 7:1 to 3:1.

4. Electrical generator system according to at least one of the preceding claims, wherein a busbar insulator element (43) electrically insulates the busbar connection, in particular the female part (42) of the busbar connection against other elements of the generator system (100).

5. Electrical generator system according to claim 4, wherein the busbar insulator element (43) comprises a tubular section (48) for an electrical insulation in radial direction and / or a disc-like element (49), in particular attached to the tubular section (48) for an electrical insulation in axial direction.

6. Electrical generator system according to claim 4 or 5, wherein the disc-like element (49) of the busbar insulator element (43) has an outer diameter being 1,2 to 2 times the inner diameter of the tubular section (48).

7. Electrical generator system according to at least one of the preceding claims, wherein the busbar connection, in particular the male part (41) and / or the female part (42) are thermally coupled to a cooling device (47), in particular a heat sink and / or an active cooling medium.

8. Electrical generator system according to at least one of the preceding claims, wherein the female part (42) of the busbar connection and / or the male part (41) of the busbar connection are electrically coupled to a transducer (45) for measuring the current and / or the voltage at the busbar connection.

9. .Electrical generator system according to at least one of the preceding claims, wherein a receiving element (46) comprises the female part (42) of the busbar connection.

10. Electrical generator system according to claim 9, wherein the terminal electrical contacts of the receiving element (46) are radially offset from each other.

11. Electrical generator system according to claim 9 or 10, wherein the female part (42) of the busbar connection comprises a tubular part and at least one connection element (51) for establishing an electric connection with the inverter unit (20) and / or the generator unit (10).

12. Electrical generator system according to at least one of the claims 9 to 11, wherein the at least one connection element (51) is positioned above or below a plane of the axis (A) of the tubular female part (42) of the busbar connection.

13. Electrical generator system according to at least one of the claims 9 to 12, wherein the receiving element (46) comprises copper or is made from copper.

14. Electrical generator system according to at least one of the claims 9 to 13, wherein the receiving element (46) comprises some insulation material (54), in particular a foil material.

15. Electrical generator system according to at least one of the preceding claims, wherein at least one part, in particular the heat sink (47) and / or the busbar connection with the receiving element (46) is axially adjustable with an adjustment means (50, 52) relative to a fixed part in the generator unit (10) and / or inverter unit (20), in particular the generator unit housing (11) and / or the inverter unit housing (21).
